(19) Europäisches Patentamt / European Patent Office / Office européen des brevets

(11) **EP 2 896 672 A2**

(12) **EUROPEAN PATENT APPLICATION**

(43) Date of publication:
**22.07.2015 Bulletin 2015/30**

(51) Int Cl.:
***C09K 3/14*** *(2006.01)*

(21) Application number: **14004120.3**

(22) Date of filing: **05.12.2014**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **24.12.2013 JP 2013266113**

(71) Applicant: **Asahi Glass Company, Limited
Tokyo 100-8405 (JP)**

(72) Inventors:
• **Yoshida, Yuiko
Tokyo, 100-8405 (JP)**
• **Yoshida, Iori
Tokyo, 100-8405 (JP)**

(74) Representative: **Müller-Boré & Partner
Patentanwälte PartG mbB
Friedenheimer Brücke 21
80639 München (DE)**

(54) **Manufacturing method of polishing agent, polishing method, and manufacturing method of semiconductor integrated circuit device**

(57) There are provided a manufacturing method of a polishing agent capable of suppressing occurrence of a polishing defect to a surface to be polished and of performing CMP at a high polishing speed, and a polishing method. The manufacturing method of the polishing agent is a manufacturing method including heating cerium oxide particles obtained by liquid phase synthesis or a slurry containing the cerium oxide particles and water at 90°C or more to 1000°C or less.

EP 2 896 672 A2

**Description**

FIELD

Embodiments of the present invention disclosed here relate generally to a manufacturing method of a polishing agent, a polishing method using that polishing agent, and a manufacturing method of a semiconductor integrated circuit device in which that polishing method is used.

BACKGROUND

Because of a tendency of high density and high definition of a semiconductor element, development of a higher microfabrication technique is demanded in recent years. Conventionally, in manufacturing of a semiconductor integrated circuit device (hereinafter, also referred to as a semiconductor device), planarization of an interlayer insulation layer, a copper-embedded wiring, or the like has been carried out by using chemical mechanical polishing (hereinafter, referred to as CMP), in order to prevent a problem that unevenness (level difference) of a layer surface exceeds a depth of focus of lithography and hampers obtaining a sufficient resolution. Importance of such planarization by CMP increases all the more as a demand for high resolution or miniaturization of a semiconductor element becomes severer.

Further, in manufacturing of a semiconductor device, a separation method (shallow trench isolation, hereinafter, referred to as STI) by a shallow trench with a small element isolation width is introduced in recent years in order to advance more sophisticated miniaturization of a semiconductor element.

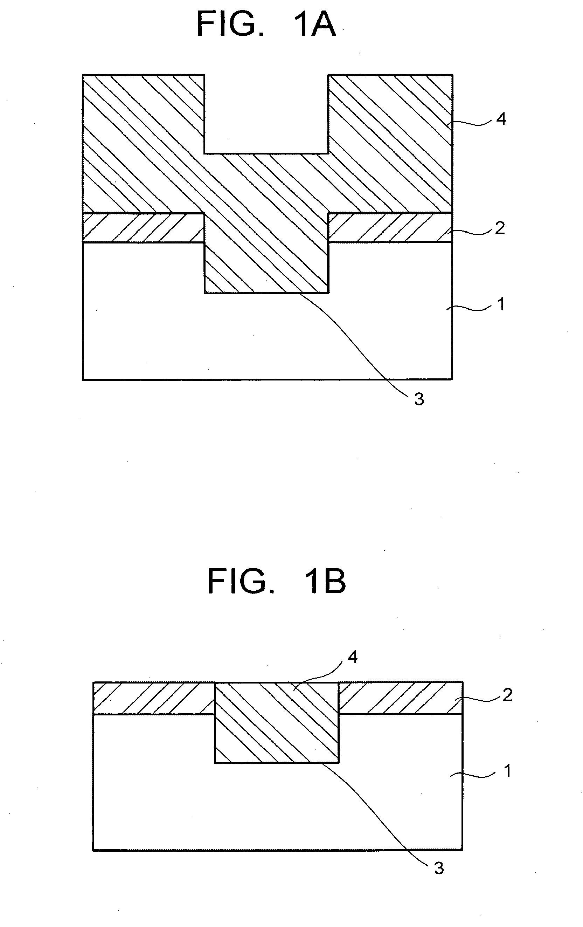

STI is a technique to form an electrically insulated element region by forming a trench in a silicon substrate and embedding an insulation layer in the trench. In STI, first, as shown in Fig. 1A, after an element region of a silicon substrate 1 is masked by a silicon nitride layer 2 or the like, a trench 3 is formed in the silicon substrate 1 and an insulation layer such as a silicon oxide layer 4 or the like is deposited in a manner to fill the trench 3. Next, by CMP, the silicon oxide layer 4 on the silicon nitride layer 2 being a protruding portion is polished and removed while the silicon oxide layer 4 in the trench 3 being a depressed portion is left, whereby an element isolation structure in which the silicon oxide layer 4 is embedded in the trench 3 is obtained as shown in Fig. 1B. In CMP in STI as above, by a configuration where a selection ratio (polishing speed of silicon oxide layer / polishing speed of silicon nitride layer) between a polishing speed of the silicon oxide layer 4 and a polishing speed of the silicon nitride layer 2 is made sufficiently high so that polishing may finish at a time that the silicon nitride layer 2 is exposed, a smoother surface can be obtained.

In manufacturing of a semiconductor device, other than planarization of the silicon oxide layer in STI as above, CMP is carried out by using a polishing agent which contains abrasive particles of fumed silica base, colloidal silica base, alumina base, ceria (cerium oxide) base or the like, in order to planarize an insulation layer of a silicon oxide or the like, or a ferroelectric layer for capacitor formed by various methods such as plasma-CVD (chemical vapor deposition), low pressure-CVD, sputtering, and electroplating. As miniaturization and high definition of an element advances, a defect (hereinafter, referred to as a polishing defect) formed in an interlayer insulation layer or an insulation layer for STI at a time of polishing, which defect causes wiring short circuit or the like and leads to reduction of a yield, becomes increasingly a large problem.

Conventionally, when a surface to be polished is an insulation layer made of a silicon oxide or the like, a polishing agent which contains high-purity cerium oxide particles have been used since the high-purity cerium oxide particles have lower hardness compared with silica-based abrasive particles and hard to cause a polishing defect (for example, see Patent Reference 1).

However, in response to further miniaturization of a semiconductor integrated circuit, demand for prevention of a polishing defect becomes further higher, and the polishing agent described in Patent Reference 1 cannot sufficiently respond to such demand. Thus, it is suggested to make a particle diameter of a cerium oxide particle being an abrasive particle smaller (for example, see Patent Reference 2). However, when a cerium oxide particle with a small particle diameter is used as an abrasive particle, a polishing speed is reduced, and there is a problem that an efficiency of polishing operation is significantly worsened.

RELEVANT REFERENCES

Patent Reference

Patent Reference 1: JP-A 2000-109803
Patent Reference 2: JP-A H08-81218

SUMMARY

The present invention is made to solve the above-described problem, and an object thereof is to provide a manufacturing method of a polishing agent capable of suppressing occurrence of a polishing defect to a surface to be polished and of polishing in a short time in CMP for planarization of an insulation layer for STI, for example, a polishing method, and a manufacturing method of a semiconductor integrated circuit device.

A first aspect of the manufacturing method of the polishing agent of the present invention includes: heating cerium oxide particles obtained by liquid phase synthesis at 90°C or more to 1000°C or less; and dispersing the cerium oxide particles in water after the heating.

Further, a second aspect of the manufacturing method of the polishing agent of the present invention includes heating a slurry containing cerium oxide particles obtained by liquid phase synthesis and water at 90°C or more to 1000°C or less.

A polishing method of the present invention is a method of performing polishing by a relative motion between a surface to be polished and a polishing pad which are brought into contact with each other while a polishing agent is supplied to the polishing pad, wherein, as the polishing agent, the polishing agent obtained by the first aspect or the second aspect of the manufacturing method of the polishing agent of the present invention is used

A manufacturing method of a semiconductor integrated circuit device of the present invention includes polishing the surface to be polished by the polishing method of the present invention.

In the present invention, a "surface to be polished" means a surface to be polished of a polishing target, and means a front surface, for example. In manufacturing of a semiconductor device, the "surface to be polished" includes a substrate surface in an intermediate stage appearing in a manufacturing process.

According to the polishing agent obtained by the manufacturing method of the present invention and the polishing method of the present invention, it is possible to suppress occurrence of a polishing defect to a surface to be polished which includes a layer of a silicon oxide, a silicon oxide containing carbon, a silicon nitride, a silicon oxynitride, a silicon carbide, amorphous silicon, polysilicon, or the like, of a semiconductor device and to polish at a high polishing speed. Besides, it is possible to perform planarization of an insulation layer for STI, for example, at a high speed while suppressing occurrence of the polishing defect, so that a manufacturing efficiency of the semiconductor device can be heightened.

BRIEF DESCRIPTION OF DRAWINGS

Fig. 1A is a cross-sectional view of a semiconductor substrate showing a method of polishing by CMP in STI.

Fig. 1B is a cross-sectional view of the semiconductor substrate showing the method of polishing by CMP in STI.

Fig. 2 is a diagram showing an example of a polishing apparatus usable for a polishing method of the present invention.

DETAILED DESCRIPTION

Hereinafter, an embodiment of the present invention will be described. The present invention is not limited to the following embodiment, and another embodiment can also belong to the category of the present invention as long as the embodiment complies with the spirit of the present invention.

[Manufacturing method of polishing agent]

A manufacturing method of a polishing agent of the present invention is a method of manufacturing a polishing agent suitable for performing CMP on a surface to be polished, particularly a polishing agent suitable for CMP of a silicon oxide layer (particularly, a silicon dioxide layer) in STI, and is a manufacturing method of a polishing agent which includes a step of heating a cerium oxide particle (hereinafter, referred to as "cerium oxide particle (A)" obtained by liquid phase composition or a slurry (hereinafter, referred to as "slurry (B)") containing the cerium oxide particle (A) and water at a predetermined temperature.

The cerium oxide particle (A) and the slurry (B) to be fed to the above-described heating step can be manufactured as follows, for example.

(Manufacturing of cerium oxide particle (A))

The cerium oxide particle (A) used in the manufacturing method of the present invention can be obtained by a liquid phase synthesis method described below, for example.

(1) After a cerium hydroxide gel is generated by adding an alkali such as an ammonia aqueous solution to a cerium (III) nitrate aqueous solution, a heating processing is carried out, whereby a slurry containing a cerium oxide particle (A) can be obtained. The slurry obtained as above is filtrated, washed, and dried, so that the cerium oxide particle (A) can be obtained.

(2) After a cerium hydroxide gel is generated by adding an alkali such as an ammonia aqueous solution to a cerium (IV) nitride ammonium aqueous solution, chemical oxidation is carried out, whereby a slurry containing a cerium oxide particle (A) can be obtained. The slurry obtained as above is filtrated, washed, and dried, so that the cerium oxide particle (A) can be obtained.

(3) A cerium (III) salt is chemically oxidized in a liquid, and a slurry containing a cerium oxide particle (A) is obtained. The slurry obtained as above is filtrated, washed, and dried, so that the cerium oxide particle (A) can be obtained.

Note that in any one of above methods (1) to (3), drying is carried out at a temperature of less than 90°C.

(Preparation of slurry (B))

A slurry (B) contains the cerium oxide particles (A) and water as a medium dispersing the cerium oxide particles (A). Water is not particularly limited, and pure water, ultrapure water, ion-exchange water, or the like is preferable in view of prevention of influence to another additive, contamination of impurities, and influence to a pH or the like. A content of water is preferable to be 50 mass% or more to 99.9 mass% or less in ratio to the entire slurry (B), and is further preferable to be 60 mass% or more to 99.8 mass% or less. Further, a content ratio of the cerium oxide particles (A) is preferable to be 0.1 mass% or more to 50 mass% or less to the entire slurry (B), and is more preferable to be 0.2 mass% or more to 40 mass% or less, in view of efficiency of polishing and prevention of aggregation of particles.

The slurry (B) can be prepared by adding the aforementioned preferable amount of water to the cerium oxide particles (A) obtained by the method selected from (1) to (3) described above, for example. Further, a later-described pH adjusting agent, dispersing agent, or the like can be added as necessary. Alternately, usable as the slurry (B) is the slurry having been generated before the cerium oxide particle (A) is obtained by filtrating, washing, and drying in the method selected from (1) to (3) described above.

(Heating step)

In the manufacturing method of the present invention, the cerium oxide particle (A), in a first aspect, and the slurry (B), in a second aspect, are heated under a temperature condition of 90°C or more to 1000°C or less in the heating step. Note that heating the slurry (B) means that the cerium oxide particle (A) which the slurry (B) contains is heated.

In the manufacturing method of the polishing agent of the present invention, in a case where the cerium oxide particles (A) are fed to the heating step as they are, a dispersing step to disperse the cerium oxide particles obtained in the heating step in water is performed after the heating step (first aspect). In a case where the slurry (B) is used in the heating step, the slurry obtained in the heating step is made to be a polishing agent as it is or by adding water (second aspect).

In a case where the polishing agent obtained by the manufacturing method of the present invention is used, when a silicon dioxide layer in STI is polished, a sufficiently high polishing speed can be obtained and occurrence of a polishing defect can be suppressed, even if a particle diameter of a cerium oxide particle is small. A reason why the polishing speed is improved as descried above by using the heat-processed cerium oxide particle is not necessarily obvious, but it is conceived that because OH groups the cerium oxide particles (A) before the heating processing have are decreased by the heating processing.

The temperature in the heating step is 90°C or more to 1000°C or less as described above. A more excellent polishing characteristic can be attained in the obtained polishing agent as the heating temperature is higher, but too high a temperature damages an industrial advantage, and the temperature is set to be 1000°C or less. A heating method of the cerium oxide particle (A) or the slurry (B) is not particularly limited as long as the temperature is the above-described heating temperature.

When the cerium oxide particle (A) is to be heated according to the first aspect, the cerium oxide particle (A) obtained by the method selected from (1) to (3) described above may be heated, for example. Heating can be carried out by holding the cerium oxide particle (A) in a firing furnace set at a temperature within the above-described range, for example. A heating time on this occasion, that is, a holding time in the firing furnace is preferable to be 0.01 hours or more to 48 hours or less. Further, the heating temperature, that is, a set temperature of the firing furnace, which differs depending on a type or the like of the firing furnace to be used, is 90°C or more to 1000°C or less. The set temperature of the firing furnace is preferable to be 90°C or more to 700°C or less. The firing furnace is not particularly limited, and a gas firing furnace, an electric firing furnace, a plasma firing furnace, or the like can be used.

As a method of heating the slurry (B) according to the second aspect, there can be cited a method of boiling the slurry (B), for example. In such a case, a boiling temperature is preferable to be 90°C or more to 100°C or less, and a boiling time is preferable to be 0.01 hours or more to 48 hours or less. Further, it is possible to irradiate a microwave to the slurry (B) by using a microwave vibrator and to heat the slurry (B) at the above-described temperature. In such a case, a frequency of the microwave is preferably 300 MHz or more to 3 THz or less and a wavelength of the microwave is preferably 0.1 mm or more to 1000 mm or less, an output is preferably 100 W or more to 500 W or less, and a heating time is preferably about 0.01 hours or more to 48 hours or less, and a heating temperature is 90°C or more and can be raised to 300°C.

Further, the slurry (B) may be heated by being injected into a high-temperature atmosphere such as high-temperature air. In this method, by bringing the slurry into contact with the high-temperature air in a state of fog drop, for example, heating can be carried out in quite a short time. A temperature of the high-temperature atmosphere can be 90°C or more to 1000°C or less, that is, the above-described heating temperature. An injection method is not particularly limited, and a two-fluid nozzle method, a three-fluid nozzle method, an ultrasonic atomization method, an electrostatic atomization method, a heating atomization method, a glass filter method, or a method of combination of the above, or the like can be used.

Further, the slurry (B) may be heated by using an autoclave, and in this method, the slurry can be made to have a higher temperature as a result of heating under a pressure higher than an atmospheric pressure. A heating condition can be set appropriately depending on a mode of the autoclave to be used, and, for example, a set temperature of the autoclave is 90°C or more to 250°C or less and a heating time is 0.01 hours or more to 48 hours or less.

Further, the slurry (B) may be heated by using a supercritical fluid apparatus of a batch type or a flow type. A supercritical fluid used in the supercritical fluid apparatus is not particularly limited, and it is possible to use water, carbon dioxide, methane, ethane, propane, ethylene, propylene, methanol, ethanol, acetone, and so on. The slurry is heated in the supercritical fluid apparatus of the above, for about 0.01 hours or more to 48 hours or less. A temperature condition is 90°C or more to 1000°C or less. The temperature condition is preferable to be 90°C or more to 700°C or less.

(Preparation of polishing agent)

When the cerium oxide particles (A) are heat-processed in the above-described heating step, the heat-processed cerium oxide particles are dispersed in water being a dispersion medium, so that a polishing agent is prepared. When the slurry (B) is heat-processed in the above-described heating step, the heat-processed slurry, that is, the slurry containing the heat-processed cerium oxide particles is made to be a polishing agent as it is, or made to be a polishing agent by addition of water being a dispersion medium as necessary. Hereinafter, "cerium oxide particle", when simply referred to, indicates the cerium oxide particle having been heat-processed under the above-described condition.

A content of water in the polishing agent is preferable to be in a ratio of 50 mass% or more to 99.9 mass% or less in relation to the entire polishing agent, is more preferable to be 70 mass% or more to 99.9 mass% or less, and is particularly preferable to be 90 mass% or more to 99.9 mass% or less. A content ratio of the cerium oxide particles in the polishing agent is preferable to be 0.1 mass% or more to 50 mass% or less in relation to the entire polishing agent, is more preferable to be 0.1 mass% or more to 30 mass% or less, and is particularly preferable to be 0.1 mass% or more to 10 mass% or less, in view of an efficiency of polishing and aggregation prevention of the particles.

When water is added in preparing the polishing agent, an amount of water which the polishing agent to be prepared finally contains can be added at a time, or can be added dividedly in a plurality of times. When the slurry (B) containing the cerium oxide particles (A) is heat-processed, the slurry can be used as a polishing agent as it is if a content of water in the slurry after heating processing is within the above-described preferable range. Further, it is possible to make the content of water in the polishing agent be the above-described preferable amount by adding water after a heating processing is applied to the slurry (B).

Further, in order to improve dispersibility of the cerium oxide particles in the polishing agent, the polishing agent obtained by the above can be subjected to a dispersing processing by using a homogenizer or the like.

Further, in order to improve dispersibility, it is preferable to carry out the dispersing processing by using a wet jet mill or the like. A set pressure of the wet jet mill at that time is preferable to be 100 MPa or more to 400 MPa or less, depending on an apparatus to be used.

It suffices that the above-described dispersing processing by the homogenizer and/or wet jet mill may be carried out after the heating processing, and the dispersing processing may be carried out when a part of the amount of water to be contained in the finally prepared polishing agent is added, or can be carried out when all the amount of water is added.

(Polishing agent)

In the polishing agent obtained by the above-described manufacturing method of the present invention, a crystallite diameter XS of the cerium oxide particle in the polishing agent is preferable to be 20 nm or more to 60 nm or less. Here, for the crystallite diameter XS, an X-ray diffraction spectrum of the cerium oxide particle is measured by an X-ray diffractometer and a half value width of a (111) surface is found in the obtained spectrum, and the crystallite diameter XS is calculated from that value by a formula of Scherrer shown below.

crystallite diameter XS (nm) = (Scherrer constant x X-ray wavelength (m)) / (half value width (2θ) x cos diffraction angle) / 10 Note that as the Scherrer constant, 0.94 is used.

When the crystallite diameter XS of the cerium oxide particle in the polishing agent is 20 nm or more to 60 nm or less, a sufficiently high polishing speed for a silicon dioxide can be obtained easily and occurrence of a polishing defect can also be suppressed easily. The above-described crystallite diameter XS of the cerium oxide particle is preferable to be 30 nm or more to 60 nm or less, and is more preferable to be 40 nm or more to 60 nm or less.

Further, an average primary particle diameter D of the cerium oxide particle in the polishing agent is preferable to be 30 nm or more to 100 nm or less, and is more preferable to be 60 nm or more to 100 nm or less. When the average primary particle diameter D is 30 nm or more to 100 nm or less, a sufficient polishing speed can be obtained easily and occurrence of a polishing defect such as a scratch in a surface to be polished can be suppressed easily. Note that when the average primary particle diameter D is less than 30 nm, there is a case where aggregation is apt to occur depending on a condition of a pH, a concentration of an additive, or the like.

Here, the average primary particle diameter D is a particle diameter obtained by observation by a scanning electron microscope (SEM), and is found by a method of image-analyzing an image of the cerium oxide particle obtained by the SEM and calculating a number average particle diameter.

Further, with regard to the cerium oxide particle in the polishing agent, a ratio (XS/D) between the crystallite diameter XS and the average primary particle diameter D is preferable to be 0.4 or more to 1.0 or less. A value (XS/D) of this ratio indicates a degree (single crystallinity) of a single crystal of the cerium oxide particle, and the degree of the single crystal becomes higher as the value comes close to 1 (one), so that a sufficiently large polishing speed for the silicon dioxide can be obtained.

(pH)

A pH of the above-described polishing agent is preferable to be 3.5 or more to 11 or less, and is further preferable to be within a range of 3.5 or more to 10 or less. When the pH is less than 3.5, the polishing speed is substantially reduced. Further, when the pH exceeds 11, dispersion stability of the cerium oxide particles being abrasive particles is hard to be maintained. When the pH of the polishing agent is within a range of 3.5 or more to 11 or less, dispersion stability of the cerium oxide particles is good and a high polishing speed can be obtained.

The above-described polishing agent may contain various kinds of inorganic acids or inorganic acid salts as a pH adjusting agent for adjusting the pH to be within the above-described predetermined range. The inorganic acid or the inorganic acid salt is not particularly limited, and there can be used, for example, a nitric acid, a sulfuric acid, a hydrochloric acid, a phosphoric acid, a boric acid, a carbonic acid, and an ammonium salt thereof or a potassium salt thereof, and so on.

Further, it is possible to add a various kinds of basic compounds as the pH adjusting agent to the above-described polishing agent. The basic compound is preferable to be water-soluble, but is not particularly limited. It is possible to use, for example, ammonia, potassium hydroxide, and quaternary ammonium hydroxide such as tetramethylammonium hydroxide (TMAH) and tetraethylammonium hydroxide, and so on.

The above-described polishing agent can contain a component other than the above-described component. As another component, a dispersing agent or the like can be cited. The dispersing agent is contained in order to disperse cerium oxide particles stably in a dispersion medium such as pure water, and an anionic, cationic, nonionic, or amphoteric surfactant can be used. The above-described polishing agent can contain one kind or more of these components.

<Polishing method and polishing apparatus>

When polishing a surface to be polished which includes a layer of a silicon oxide, a silicon oxide containing carbon, a silicon nitride, a silicon oxynitride, a silicon carbide, amorphous silicon, polysilicon, or the like, of a semiconductor device by using the polishing agent obtained by the above-described manufacturing method of the present invention, a method is preferable in which polishing is performed by a relative motion between the surface to be polished and a polishing pad which are brought into contact with each other while the polishing agent is supplied to the polishing pad.

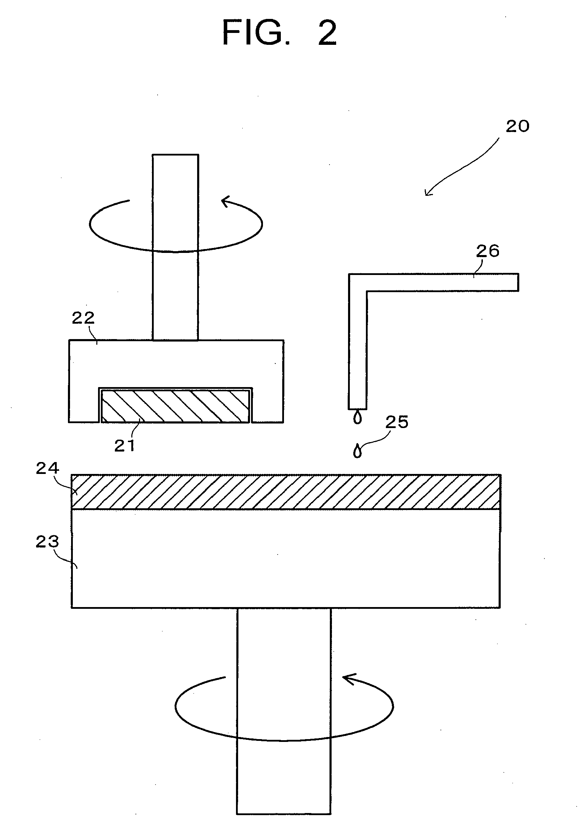

In the above-described polishing method, as for a polishing apparatus, a conventionally known polishing apparatus can be used. Fig. 2 is a diagram showing an example of the polishing apparatus usable for the polishing method of the present invention.

The polishing apparatus 20 has a polishing head 22 to hold a semiconductor device 21, a polishing platen 23, a polishing pad 24 pasted on a surface of the polishing platen 23, and a polishing agent supply piping 26 to supply the polishing agent 25 to the polishing pad 24. It is configured that a surface to be polished of the semiconductor device 21 held by the polishing head 22 is brought into contact with the polishing pad 24 to perform polishing by a relative rotational motion of the polishing head 22 and the polishing platen 23 while the polishing agent 25 is being supplied from the polishing agent supply piping 26. Note that the polishing apparatus used in the embodiment of the present invention is not limited to one having such a structure.

The polishing head 22 may make not only a rotational motion but also a linear motion. Further, the polishing platen 23 and the polishing pad 24 may have a size nearly equal to or smaller than a size of the semiconductor device 21. In that case, it is preferable to configure that an entire surface of the surface to be polished of the semiconductor device 21 is able to be polished by a relative motion of the polishing head 22 and the polishing platen 23. Further, the polishing platen 23 and the polishing pad 24 are not necessarily ones which make rotational motions, and may be ones which move in one direction by a belt system, for example.

A condition of polishing by such a polishing apparatus 20 is not particularly limited, and a polishing pressure can be further heightened to improve the polishing speed by giving a load to the polishing head 22 in pressing against the polishing pad 24. The polishing pressure is preferable to be about 0.5 kPa or more to 50 kPa or less, and is more preferable to be about 3 kPa or more to 40 kPa or less in view of uniformity, flatness, and prevention of a polishing defect such as a scratch in the surface to be polished of the semiconductor device 21 in the polishing speed. The numbers of rotations of the polishing platen 23 and the polishing head 22 are preferable to be about 50 rpm or more to 500 rpm or less, but is not limited thereto. Further, a supply amount of the polishing agent 25 is appropriately adjusted according to a composition of the polishing agent, the above-described polishing condition, and so on.

As the polishing pad 24, one made of nonwoven fabric, foamed polyurethane, a porous resin, a nonporous resin, or the like is usable. Further, in order to accelerate supply of the polishing agent 25 to the polishing pad 24 or to make a predetermined amount of the polishing agent 25 stay in the polishing pad 24, the surface of the polishing pad 24 may be subjected to a grooving processing of a lattice-shape, a concentric shape, a spiral shape, or the like. Further, as necessary, polishing may be performed while a pad conditioner is brought into contact with the surface of the polishing pad 24 to perform conditioning of the surface of the polishing pad 24.

According to the polishing method of the present invention, a surface to be polished made of a silicon oxide can be polished at a high polishing speed in a CMP processing such as planarization of an interlayer insulation layer and plananzation of an insulation layer for STI in manufacturing of a semiconductor device. Further, it is possible to suppress occurrence of a polishing defect to the surface to be polished, so that a semiconductor device can be obtained at a high yield.

EXAMPLES

Hereinafter, the present invention will be described concretely based on working examples, but the present invention is not limited to the following description. Examples 1 to 6 are working examples of the present invention, while the example 7 is a comparative example. Further, in the following examples, "%" means "mass%" unless mentioned otherwise. Further, a concentration of abrasive particles and an average primary particle diameter D, an average secondary particle diameter, and a crystallite diameter XS of cerium oxide particles were each measured by the following methods.

(Concentration of abrasive particles)

A concentration of the abrasive particles was measured by using a moisture meter (manufactured by SHIMAZU CORPORATION, trade name; MOC-120H).

(Average primary particle diameter D)

An average primary particle diameter D was found by analyzing an image of a cerium oxide particle obtained by a scanning electron microscope (SEM) (manufactured by Hitachi High-Technologies Corporation, apparatus name: S-4800) by using image analysis software (manufactured by Mountech Co., Ltd., trade name: Mac-View ver. 3.5). Analysis was carried out by approximating the image of the particle to a circle, particle diameters of the 50 particles in the image were measured, and a value obtained by number-averaging was adopted as an average primary particle diameter D.

(Average secondary particle diameter)

An average secondary particle diameter was measure by using a laser scattering diffraction apparatus (manufactured by Horiba, Ltd., trade name: LA-920).

(Crystallite diameter XS)

For a crystallite diameter XS, an X-ray diffraction spectrum was measured by an X-ray diffractometer (manufactured by Rigaku Corporation, apparatus name: TTR-III), and the crystallite diameter XS was calculated from a half value width of an obtained (111) surface by the following formula.

$$\text{crystallite diameter XS (nm)} = (\text{Scherrer constant} \times \text{X-ray wavelength (m)}) \, / \, (\text{half value width}$$

$$(2\theta) \times \cos \text{ diffraction angle}) \, / \, 10$$

Further, in preparation of the polishing agents of the examples 1 to 4, as a homogenizer, US-600TCVP (apparatus name) manufactured by NIHONSEIKIKAISHA LTD. was used, and as a wet jet mill, Star Burst Mini (apparatus name) manufactured by Sugino Machine Ltd was used. Further, in polishing agent preparation of the example 6, as a microwave heating apparatus, MicroSYNTH manufactured by Milestone Srl was used.
Further, as a slurry (B) containing cerium oxide particles (A), a colloidal ceria containing the cerium oxide particles (A) as abrasive particles was used.

Example 1

A colloidal ceria (manufactured by Rhodia, trade name: HC60, concentration of abrasive particles: 30%) of 500 g was dried in a thermostatic oven of 70°C for three days. An obtained dried body was ground into a powder shape by a mortar and thereafter put into a crucible, and firing was carried out at 690°C for five hours by a firing furnace. Next, a powdered cerium oxide after firing was roughly disintegrated by a mortar, 948.5 g of pure water and 1.5 g of 1% nitric acid aqueous solution were added in relation to 50 g of obtained cerium oxide particles in powder form, and preparation was performed so that an entire amount becomes 1000 g. Then, after an obtained slurry was dispersing processed by a homogenizer, a wet jet mill was used, with a pressure being set at 200 MPa, to carry out a processing until $D_{50}$ of an average secondary particle diameter becomes 120 nm. To 250 g of the slurry (1) obtained as above, 4750 g of pure water was added and mixed, to obtain a polishing agent (1).
Further, the above-described slurry (1) was re-dried at 70°C for three days, to obtain cerium oxide particles. An average primary particle diameter D and a crystallite diameter XS of the cerium oxide particles obtained as above were each measured by the above-described methods. Measurement results are shown in Table 1.

Example 2

A colloidal ceria (manufactured by Rhodia, trade name: HC42, concentration of abrasive particles: 30%) of 500 g was dried in a thermostatic oven of 70°C for three days. An obtained dried body was ground into a powder shape by a mortar and thereafter put into a crucible, and firing was carried out at 690°C for five hours by a firing furnace. Next, a powdered cerium oxide after firing was roughly disintegrated by a mortar, 948.5 g of pure water and 1.5 g of 1% nitric acid aqueous solution were added in relation to 50 g of obtained cerium oxide particles in powder form, and preparation was performed so that an entire amount becomes 1000 g. Then, after an obtained slurry was dispersing processed by a homogenizer, a wet jet mill was used, with a pressure being set at 200 MPa, to carry out a processing until $D_{50}$ of an average secondary particle diameter becomes 110 nm. To 250 g of the slurry (2) obtained as above, 4750 g of pure water was added and mixed, to obtain a polishing agent (2).
Further, the slurry (2) was re-dried at 70°C for three days, to obtain cerium oxide particles. An average primary particle diameter D and a crystallite diameter XS of the cerium oxide particles obtained as above were each measured by the above-described methods. Measurement results are shown in Table 1.

Example 3

A colloidal ceria (manufactured by Rhodia, trade name: HC30, concentration of abrasive particles: 30%) of 500 g was dried in a thermostatic oven of 70°C for three days. An obtained dried body was ground into a powder shape by a mortar and thereafter put into a crucible, and firing was carried out at 690°C for five hours by a firing furnace. Next, a powdered cerium oxide after firing was roughly disintegrated by a mortar, 948.5 g of pure water and 1.5 g of 1% nitric acid aqueous solution were added in relation to 50 g of obtained cerium oxide particles in powder form, and preparation was performed so that an entire amount becomes 1000 g. Then, after an obtained slurry was dispersing processed by a homogenizer, a wet jet mill was used, with a pressure being set at 200 MPa, to carry out a processing until $D_{50}$ of an

average secondary particle diameter becomes 100 nm. To 250 g of the slurry (3) obtained as above, 4750 g of pure water was added and mixed, to obtain a polishing agent (3).

Further, the slurry (3) was re-dried at 70°C for three days, to obtain cerium oxide particles. An average primary particle diameter D and a crystallite diameter XS of the cerium oxide particles obtained as above were each measured by the above-described methods. Measurement results are shown in Table 1.

Example 4

A colloidal ceria (manufactured by Rhodia, trade name: HC60, concentration of abrasive particles: 30%) of 500 g was dried in a thermostatic oven of 70°C for three days. An obtained dried body was ground into a powder shape by a mortar and thereafter put into a crucible, and firing was carried out at 150°C for five hours by a firing furnace. Next, a powdered cerium oxide after firing was roughly disintegrated by a mortar, 948.5 g of pure water and 1.5 g of 1% nitric acid aqueous solution were added in relation to 50 g of obtained cerium oxide particles in powder form, and preparation was performed so that an entire amount becomes 1000 g. Then, after an obtained slurry was dispersing processed by a homogenizer, a wet jet mill was used, with a pressure being set at 200 MPa, to carry out a processing until $D_{50}$ of an average secondary particle diameter becomes 120 nm. To 250 g of the slurry (4) obtained as above, 4750 g of pure water was added and mixed, to obtain a polishing agent (4).

Further, the slurry (4) was re-dried at 70°C for three days, to obtain cerium oxide particles. An average primary particle diameter D and a crystallite diameter XS of the cerium oxide particles obtained as above were each measured by the above-described methods. Measurement results are shown in Table 1.

Example 5

A colloidal ceria (manufactured by Rhodia, trade name: HC60, concentration of abrasive particles: 30%) of 500 g was put into a vessel and heated (boiled) at 90°C for five hours. Next, to 41.6 g of the slurry (5) obtained as above, 4958.4 g of pure water was added and mixed, to obtain a polishing agent (5).

Further, the slurry (5) was re-dried at 70°C for three days, to obtain cerium oxide particles. An average primary particle diameter D and a crystallite diameter XS of the cerium oxide particles obtained as above were each measured by the above-described methods. Measurement results are shown in Table 1.

Example 6

A colloidal ceria (manufactured by Rhodia, trade name: HC60, concentration of abrasive particles: 30%) of 200 g was put into a 200 mL pressure resistant vessel made of quartz and the pressure resistant vessel was sealed. Next, by using the above-described microwave heating apparatus (manufactured by Milestone Srl, MicroSYNTH), a microwave of 500 W in output and 2.45 GHz in frequency was irradiated for two minutes, to raise a temperature of the inside of the pressure resistant vessel to 180°C. Thereafter, the temperature was held at 180°C for one minute and then slow cooling was carried out. To 41.6 g of the slurry (6) obtained as above, 4958.4 g of pure water was added and mixed, to obtain a polishing agent (6).

Further, after the slurry (6) was re-dried at 70°C for three days to obtain cerium oxide particles, an average primary particle diameter D and a crystallite diameter XS of the obtained cerium oxide particles were each measured by the above-described methods. Measurement results are shown in Table 1.

Example 7

To 41.6 g of a colloidal ceria (manufactured by Rhodia, trade name: HC30, concentration of abrasive particles: 30%), 4958.4 g of pure water was added and mixed, to obtain a polishing agent (7). Further, after the above-described colloidal ceria was dried at 70°C for three days to obtain cerium oxide particles, an average primary particle diameter D and a crystallite diameter XS of the obtained cerium oxide particles were each measured by the above-described methods. Measurement results are shown in Table 1.

Next, polishing characteristics of the polishing agents (1) to (7) obtained in the examples 1 to 7 were evaluated by methods described below. Evaluation results are shown in Table 1 together with manufacturing conditions (heating conditions of cerium oxide particles (A)) of the polishing agents. Note that a mark "(A)" in a mode column of the heating step in Table 1 indicates that a heating processing was carried out in a mode of the cerium oxide particles (A). A mark "(B)" indicates that a heating processing was carried out in a mode of the slurry (B), that is, the colloidal ceria. Further, degrees of single crystals (XS/D) in the polishing agents (1) to (7) are shown in Table 2.

(Evaluation of polishing characteristic)

Experiments to measure polishing speeds were carried out in order to evaluate polishing characteristics.

<Object to be polished>

As a patterned object to be polished, an STI pattern wafer (manufactured by International SEMATECH, trade name: 864CMP000) was used. A wafer size was 8 inches, and in the wafer was formed a plurality of stripe patterns modeling after a pattern of STI, with a pattern width of 0.5 $\mu$m or more to 500 $\mu$m or less and a pattern density of about 10% or more to 90% or less, at a pattern interval of 100 $\mu$m. In the STI pattern wafer, a layer thickness of an SiN layer formed as a mask on an active region was 90 nm, and a depth of a trench was 350 nm. The entire surface of the wafer was covered by a silicon dioxide layer of a layer thickness of 500 nm which was layer-formed from tetraethoxysilane being material, by plasma CVD.

<Polishing machine and polishing condition>

As a polishing machine, a fully automatic CMP apparatus (manufactured by Applied Materials, Inc., apparatus name: Mirra) was used. As a polishing pad, a double layer pad (manufactured by Rodel, Inc., trade name: K-groove, IC-1400) was used, and conditioning was carried out by using a diamond disk (manufactured by 3M Company, trade name: A165). Polishing was performed for two minutes with a supply speed of a polishing agent being 200 cm$^3$/min, the number of rotations of a polishing platen being 77 rpm, and a polishing pressure being 3 psi.

Measurement of the polishing speed was carried out by measuring a layer thickness of a part described below of the above-described STI pattern wafer being the object to be polished by using an optical thicknessmeter (manufactured by KLA-Tencor Corporation, apparatus name: UV-1280SE). In other words, from layer thicknesses before and after polishing of a silicon dioxide layer of an active region (element region) portion of a pattern forming part constituted by an active region of a width of 70 $\mu$m and a trench region of a width of 30 $\mu$m in the above-described STI pattern wafer, the polishing speed was calculated by the following formula.

$$\text{polishing speed V (nm/min)} = (\text{thickness (nm) before polishing} - \text{thickness (nm) after 2-minute polishing}) / 2 \text{ minute}$$

[Table 1]

| | Abbreviation for polishing agent | Manufacturing condition, etc. | | | | Polishing agent evaluation result | | |
|---|---|---|---|---|---|---|---|---|
| | | Colloidal ceria trade name | Heating step | | | Polishing speed V (nm/min) | Crystallite diameter XS (nm) | Average primary particle diameter D (nm) |
| | | | Mode | Heating method | Temperature /time | | | |
| Example 1 | (1) | HC60 | (A) | Firing furnace | 690°C/5Hr | 231.1 | 42 | 85 |
| Example 2 | (2) | HC42 | (A) | Firing furnace | 690°C/5Hr | 84.0 | 30 | 55 |
| Example 3 | (3) | HC30 | (A) | Firing furnace | 690°C/5Hr | 19.5 | 27 | 42 |
| Example 4 | (4) | HC60 | (A) | Firing furnace | 150°C/5Hr | 231.1 | 47 | 85 |
| Example 5 | (5) | HC60 | (B) | Boiling | 90°C/5Hr | 189.0 | 47 | 85 |
| Example 6 | (6) | HC60 | (B) | Microwave irradiation | 180°C/lmin | 179.3 | 47 | 85 |
| Example 7 | (7) | HC30 | Not heated | | | 11.3 | 27 | 42 |

EP 2 896 672 A2

From the results of Table 1, it is found that when the polishing agents of the examples 1 to 6 containing the cerium oxide particles obtained by heat-processing the cerium oxide particles (A) were used, the polishing speeds V were larger compared with a case of the polishing agent of the example 7 in which the cerium oxide particles (A) were used unprocessed.

[Table 2]

|  | Degree of single crystal XS/D |
| --- | --- |
| Example 1 | 0.49 |
| Example 2 | 0.55 |
| Example 3 | 0.65 |
| Example 4 | 0.55 |
| Example 5 | 0.55 |
| Example 6 | 0.55 |
| Example 7 | 0.65 |

From Table 2, in the cerium oxide particles in the polishing agents obtained in the examples 1 to 7, the above-described degrees of a single crystal XS/D are within a range of 0.4 or more to 1 or less.

According to the present invention, it is possible to suppress occurrence of a polishing defect to a surface to be polished and to perform polishing at a high polishing speed. Therefore, for example, planarization of an insulation layer for STI can be carried out at a high speed while occurrence of a polishing defect is suppressed, and a manufacturing efficiency of a semiconductor device can be heightened.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

**Claims**

1. A manufacturing method of a polishing agent, comprising:

    heating cerium oxide particles obtained by liquid phase synthesis at 90°C or more to 1000°C or less; and
    dispersing the cerium oxide particles in water after the heating.

2. The manufacturing method of the polishing agent according to claim 1,
   wherein the heating is heating the cerium oxide particles in a firing furnace.

3. The manufacturing method of the polishing agent according to claim 2,
   wherein the firing furnace is one kind or more selected from a gas firing furnace, an electric firing furnace, and a plasma firing furnace.

4. A manufacturing method of a polishing agent, comprising
   heating a slurry containing cerium oxide particles obtained by liquid phase synthesis and water, at 90°C or more to 1000°C or less.

5. The manufacturing method of the polishing agent according to claim 4,
   wherein the heating is one kind or more selected from boiling the slurry, irradiating a microwave to the slurry, injecting the slurry into a high-temperature atmosphere, and heating the slurry in an autoclave or a supercritical fluid apparatus.

6. A polishing method of performing polishing by a relative motion between a surface to be polished and a polishing pad which are brought into contact with each other while a polishing agent is supplied to the polishing pad,
   wherein the polishing agent obtained by the manufacturing method according to any one of claims 1 to 5 is used as the polishing agent.

7. A manufacturing method of a semiconductor integrated circuit device, comprising polishing the surface to be polished by the polishing method according to claim 6.

# FIG. 1A

# FIG. 1B

# FIG. 2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000109803 A
- JP H0881218 A